# EUROPÄISCHE PATENTSCHRIFT

(11) **EP 3 479 932 B1**
(45) Veröffentlichungstag und Bekanntmachung des Hinweises auf die Patenterteilung: **01.12.2021**
(21) Anmeldenummer: 18202944.7
(22) Anmeldetag: 26.10.2018
(51) Int. Cl.: B22F 1/00, B22F 1/02, B22F 9/02, B22F 10/34, B33Y 70/00, C22C 29/04, C22C 29/06, C22C 29/08, C22C 29/10, C23C 4/10, C23C 14/18, C23C 14/22, B22F 10/14, B22F 10/28

(54) **VERFAHREN ZUR HERSTELLUNG VON GESINTERTEM HARTMETALLGRANULAT**
MANUFACTURING PROCESS OF SINTERED HARD METAL GRANULES
PROCÉDÉ DE FABRICATION DE GRANULES FRITTÉES À BASE DE MÉTAL DUR

(30) Priorität: 03.11.2017 DE 102017125734
(43) Veröffentlichungstag der Anmeldung: 08.05.2019
(73) Patentinhaber: Fraunhofer-Gesellschaft zur Förderung der angewandten Forschung, 80686 München (DE)
(72) Erfinder: PÖTSCHKE, Johannes, 01277 Dresden (DE)
(74) Vertreter: Rauschenbach, Marion

(56) Entgegenhaltungen:
- WO-A1-2015/169132
- WO-A1-2017/132710
- WO-A1-2017/150340
- US-A1- 2015 147 572
- PRIIDU PEETSALU ET AL: "Characterization of WC-Co composite thermal spray powders and coatings", PROC. ESTONIAN ACAD. SCI. ENG, Bd. 12, 1. Januar 2006 (2006-01-01), Seiten 435-444, XP055571532,
- Karin Andersson: "Aqueous Processing of WC-Co Powders Aqueous processing of WC-Co powders", , 1 January 2001 (2001-01-01), XP055682613, ISBN: 978-91-7-283071-4 Retrieved from the Internet: URL:http://www.diva-portal.org/smash/get/d iva2:9566/FULLTEXT01.pdf

## Beschreibung

Die Erfindung bezieht sich auf die Gebiete der Hartmetallwerkstoffe und der keramischen und/oder pulvermetallurgischen Verfahrenstechnik und betrifft ein Verfahren zur Herstellung von gesintertem Hartmetallgranulat, wie es beispielsweise für die Herstellung von Verschleißteilen oder Werkzeugen mit Hartmetallen eingesetzt werden kann.

Die Herstellung von Hartmetallkörpern, die im Grünzustand neben organischen Bindemitteln die Hartmetallausgangspulver enthalten, mittels Pressverfahren, Extrusion oder MIM/CIM und dem anschließenden Sintern ist nach dem Stand der Technik bekannt. Dabei können Hartmetallbauteile mit verschiedener Zusammensetzung hergestellt werden.

Mit diesen bekannten Herstellungsverfahren sind hinsichtlich der Geometrie der herzustellenden Bauteile Einschränkungen vorhanden, die mit diesen Technologien nicht beseitigbar sind.

Für eine Designfreiheit zur Herstellung von komplexen Hartmetallbauteilen ist der Einsatz von Additiven Fertigungsverfahren erforderlich. Bei solchen Fertigungsverfahren werden die Bauteile gemäß einem 3D-Modell, welches mit einem Computer generiert wird, erzeugt, in dem das 3D-Modell quasi in dünne Scheiben geschnitten und danach das Bauteil scheibenweise hergestellt wird.

Ein solches Additives Fertigungsverfahren ist das sogenannte 3D-Binderdrucken (binder jetting). Dabei wird schichtweise Pulver oder vorgesintertes Hartmetallgranulat auf eine Grundfläche aufgebracht und entsprechend den Schichten des Computermodells mittels einer Binderdruckflüssigkeit lokal verfestigt.

Nach der Fertigstellung des kompletten Bauteils mittels schichtweisem Pulver/Granulat- und Binderdruckflüssigkeitsauftrag wird gegebenenfalls nach einem Nachhärten des Bindemittels das lose Pulver oder Granulat entfernt und der so entstandene Grünkörper einem Entbinderungs- und Sinterprozess unterworfen.

Der erfolgreiche Einsatz eines solchen 3D-Binderdruckens für Hartmetallbauteile mit hohen Bindemetallgehalten von über 19 Vol.-% ist bekannt (J. Pötschke et al: Additive Manufacturing Of Hardmetals, Euro PM2017 Proceedings (ISBN:978-1-899072-47-7)). Bauteile mit geringeren Bindemetallgehalten von ≤ 19 Vol.-% sind mittels des 3D-Binderdruckens bisher nicht möglich, da die bekannten kommerziellen Hartmetall-Pulver/- Granulate eine zu geringe Schüttdichte aufweisen und nicht weiter verdichtet werden können. Eine höhere Verdichtung könnte nur durch einen höheren Gehalt an Bindemetall erreicht werden, da bei der Verdichtung von Hartmetallgrünkörpern mit geringen Gründichten große Materialumlagerungen realisiert werden müssen, die primär durch das Aufschmelzen der Bestandteile erreicht werden können. Bei Hartmetallen schmelzen nur die metallischen Komponenten auf, so dass die Materialumlagerungen nur bei hohen Gehalten an Bindemetallen erreichbar sind.

Hinzu kommt, dass bei konventionellen, kommerziellen Hartmetall-Pulvern/-Granulaten der erreichbare Grünkörper nach dem Entbindern keine ausreichende Festigkeit aufweist, um nachfolgend gehandhabt und/oder weiterverarbeitet (Sintern) zu werden.

Nachteilig bei diesem Verfahren ist, dass es beim nachfolgenden Sintern der Bauteilen oft zum Auseinanderfallen der Bauteile kommt, da durch das Entfernen der organischen Bindemittel im Wärmebehandlungsprozess (Entbinderung) die Pulverteilchen und insbesondere die vorgesinterten Hartmetallgranulate keinen Kontakt mehr zueinander haben und somit die Bauteilform nicht oder nicht mehr vollständig aufrechterhalten werden kann.

Mit anderen Additiven Fertigungsverfahren kann mit lokalem direktem Energieeintrag bereits eine höhere Festigkeit des Grünkörpers realisiert werden, wie beispielsweise mittels des Lasersinterns (Y. Xiong et al: Powder Metallurgy Vol. 53, Iss. 1, 2010; T. Gläser, Untersuchungen zum Lasersintern von Wolframcarbid-Kobalt, Dissertation 2010; Generative Fertigung von Extrusionswerkzeugen aus Hartmetall-GENIAL (BMBF)).

Beim Lasersintern werden teilweise sehr hohe Temperaturen benötigt, um insbesondere die vorgesinterten Hartmetallgranulate vor allem mit den darunter liegenden Schichten an vorgesinterten Hartmetallgranulaten miteinander versintern zu können. Da dies oft nicht in ausreichendem Maße realisiert werden kann, kommt es bei diesem Verfahren oft zu Schädigungen des Hartmetallgefüges, da insbesondere zu hohe lokale Energieeinträge wiederum zu einer Zersetzung des Wolframkarbids in den Hartmetallgranulaten oder, im Beisein von Kobalt und/oder Nickel, es zur Ausbildung einer unerwünschten Etaphase kommen kann.

Vorgesinterte und teilverdichtete Hartmetallgranulate aus WC-Co, Cr₃C₂-Ni sind beispielsweise aus Faisal, N.H. et al: J. Therm. Spray Tech. (2011) 20, 1071; S.M. Nahvi et al: Surface and Coatings Techn., (2016) 286, 95-102; G. Bolelli et al: Surface and Coatings Techn. (2012) 206, 4079-4094) bekannt.

Weiter ist nach der WO2017/178319 A1 ein 3D-Drucken von Cermets oder carbidischen Hartstoffen bekannt. Danach werden 65-85 Gew.-% poröse carbidische Hartstoffe oder Hartstoffe mit 15-35 Gew.-% dichten carbidischen Hartstoffen oder Hartstoffen gemischt und diese Pulvermischung wird zum 3D-Drucken von Grünkörpern eingesetzt, die nachfolgend gesintert werden.

Ebenfalls ist aus der WO 2015/162206 A2 ein Verfahren zur Herstellung von Hartstoffen oder carbidischen Hartstoffpulvern bekannt, bei dem ein Pulver aus dichten und sphärischen carbidischen Hartstoffgranulaten aus einem Metall, einem Hartstoff und einem organischen Binder, mit Sinterhilfsmitteln gemischt und anschließend gesintert wird.

Gemäß der WO 2015/169132 A1 ist ein Verfahren zur Herstellung eines WC-Co-Pulvers bekannt, welches mittels thermischen Spritzens realisiert wird. Dazu werden WC und eine wasserlösliches Co-Salz und eine Kohlenstoffquelle und Wasser zu einer Suspension gemischt und gemahlen und die Suspension sprühgranuliert. Dabei wird das mit Co-Salz beschichtete WC-Precursor-Pulver zu WC reduziert und das WC-Co-Pulver hergestellt.

Nach P. Peetsalu et al: Proc. Estonian Acad. Sci. Eng., Bd. 12, 1. Jan. 2006, S. 435-444, ist die Charakterisierung von thermisch gespritztem WC-Co-Pulver als Beschichtung bekannt. Dabei wird WC-Co-Hartmetall-Pulver als Beschichtungsmaterial eingesetzt.

Weiterhin ist aus der WO 2017/132810 A1 das schichtweise Herstellen eines dreidimensionalen Hartmetallkörpers beschrieben, wobei schichtweise Hartmetall-Pulver aufgebracht und selektiv verfestigt wird. Als Materialien werden die üblichen und bekannten Materialien für Hartmetalle eingesetzt.

Aus K. Andersson, 1. Jan. 2001, XP055682613, ISBN: 978-91-7-283071-4 ist eine zusammenfassende Darstellung zu prinzipiellen Fragen der Handhabung einer wässrigen WC-Co-Pulversuspension bekannt.

Ebenfalls sind aus der WO 2017/150340 A1 gesinterte Hartmetallgranulate bekannt, bei denen überwiegend Hartmetall an der Oberfläche der Granalien angeordnet ist,

Und weiter ist aus US 2015/147572 A1 ein Cermet-Pulver bekannt, welches keine Bruchgrenze in einem Spannungs-Dehnungs-Diagramm aufweist, wobei das Cermet-Pulver auch aus gesinterten Hartmetallgranulaten bestehen kann, bei denen die Konzentration von Hartstoff WC an der Oberfläche deutlich größer ist als im Inneren der Granalien.

Nachteilig bei den Lösungen des Standes der Technik ist es, dass Hartmetallgrünkörper bei Einsatz von vorgesinterten Hartmetallgranulaten oft nicht mit ausreichender Gründichte und Festigkeit herstellbar sind.

Aufgabe der vorliegenden Erfindung ist es, ein Verfahren zur Herstellung von gesintertem Hartmetallgranulat anzugeben, mit welchem Hartmetallgrünkörper und -sinterkörper herstellbar sind, die eine hohe Gründichte und hohe Grünfestigkeit aufweisen.

Die Aufgabe wird durch die im Anspruch 1 angegebene Erfindung gelöst. Vorteilhafte Ausgestaltungen sind Gegenstand der Unteransprüche.

Bei dem erfindungsgemäßen Verfahren zur Herstellung von gesintertem Hartmetallgranulat, werden Hartstoffe und Bindemetall mit oder ohne Zusätze gemischt und nachfolgend granuliert und teilverdichtet und werden nachfolgend
- einer Sinterung der Hartmetallgranalien und Steuerung der Abkühlgeschwindigkeit im Dreiphasenbereich WC, Co-flüssig und C-fest unterworfen,
   oder
- einer Beschichtung der Hartstoffe mit Bindemetall mittels Physical vapor depositon/Plasmaenhaced chemical vapor deposition (PVD/PECVD) unterworfen,
   oder
- einer Entbinderung der Granalien durch Einstellung eines Kohlenstoffgradienten mit erhöhtem Kohlenstoff im Inneren der Granalien und einer nachfolgenden Sinterung unterworfen,
wodurch die überwiegende Anzahl an Granalien eine inhomogene Verteilung von Hartstoff und Bindemetall in der einzelnen Granalie aufweist, wobei die Konzentration des Bindemetalls an der Oberfläche der einzelnen Granalie in der Summe um mindestens 25 % größer ist, als im Inneren der Granalie.

Vorteilhafterweise werden als Hartstoffe WC, TiC, TiCN, NbC, TaC, Cr₃C₂, VC und/oder Mo₂C und/oder deren Mischungen eingesetzt.

Ebenfalls vorteilhafterweise werden als Bindemetalle Co, Fe und/oder Ni und/oder deren Mischungen eingesetzt.

Weiterhin vorteilhafterweise werden als Zusätze Cr₃C₂, VC und/oder TaC als Kornwachstumshemmer in den Granalien eingesetzt.

Und auch vorteilhafterweise werden die Hartstoffe mit einer mittleren Korngröße von 0,05 bis 7 µm, welcher mittels eines Fisher Sub-Sieve Sizer klassiert worden ist, in den Hartmetallgranalien eingesetzt.

Vorteilhaft ist es auch, wenn eine Konzentration des Bindemetalls an der Oberfläche der einzelnen Granalie eingestellt wird, die in der Summe um 25 bis 2000 % größer ist, als im Inneren der Granalie.

Ebenfalls vorteilhaft ist es, wenn die Verteilung des Bindemetalls an der Oberfläche der Granalien realisiert wird, die möglichst gleichmäßig über die gesamte Oberfläche der einzelnen Granalie verteilt ist.

Weiterhin vorteilhaft ist es, wenn eine möglichst vollständigen Oberflächenschicht aus Bindemetall auf den einzelnen Granalien realisiert wird.

Die Verwendung von hergestelltem gesinterten Hartmetallgranulat erfolgt für additive Fertigungsverfahren und/oder für das Thermische Spritzen.

Vorteilhafterweise erfolgt die Verwendung für Pulverbett-basierte additive Fertigungsverfahren, wie das 3D-Pulverdrucken (Binder jetting) oder selektives Lasersintern/-schmelzen oder Elektronenstrahlschmelzen.

Mit der erfindungsgemäßen Lösung wird es erstmals möglich, ein Verfahren zur Herstellung von gesintertem Hartmetallgranulat anzugeben, mit welchem Hartmetallgrünkörper und - sinterkörper herstellbar sind, die eine hohe Grün- und Sinterdichte und eine hohe Grün- und Sinterfestigkeit aufweisen.

Erreicht wird dies erfindungsgemäß durch ein Verfahren zur Herstellung von gesintertem Hartmetallgranulat, bei dem Hartstoffe und Bindemetall mit oder ohne Zusätze gemischt und nachfolgend granuliert und teilverdichtet werden.

Nachfolgend kann entweder
- eine Sinterung der Hartmetallgranalien und Steuerung der Abkühlgeschwindigkeit im Dreiphasenbereich WC, Co-flüssig und C-fest realisiert werden,
   oder
- einer Beschichtung der Hartstoffe mit Bindemetall mittels Physical vapor depositon/Plasmaenhaced chemical vapor deposition (PVD/PECVD) realisiert werden,
   oder
- einer Entbinderung der Granalien durch Einstellung eines Kohlenstoffgradienten mit erhöhtem Kohlenstoff im Inneren der Granalien und einer nachfolgenden Sinterung realisiert werden,
wodurch die überwiegende Anzahl an Granalien eine inhomogene Verteilung von Hartstoff und Bindemetall in der einzelnen Granalie aufweist. Dabei ist es von besonderer Bedeutung, dass diese inhomogene Verteilung so vorliegt, dass das Bindemetall dabei eine Konzentration des Bindemetalls an der Oberfläche der einzelnen Granalie aufweist, die in der Summe um mindestens 25 % größer ist, als die Konzentration des Bindemetalls im Inneren der Granalie.

Durch diese Konzentrationsangaben in Summe wird einerseits definiert, dass es einen deutlichen Konzentrationsunterschied zwischen Inneren und Oberfläche der Granalie bezüglich des Bindemetalls gibt. Andererseits wird damit auch definiert, dass sich das Bindemetall nicht homogen verteilt auf der Oberflächen befinden muss.

Bei den erfindungsgemäß hergestellten Hartmetallgranulaten wird durch die Anordnung der Bindemetallphase in höherer Konzentration in Summe an der Oberfläche erreicht, dass an den Stellen, an denen die Hartmetallgranulate bei der nachfolgenden Verarbeitung mittels Additiver Fertigungsverfahren an der Oberfläche eine deutlich höhere Konzentration an Bindemetall aufweisen, wodurch bei Temperaturerhöhung deutlich mehr Schmelzphase an der Oberfläche der Granalien vorliegt und so einerseits eine bessere Versinterung der Hartmetallgranalien erreicht wird, gleichzeitig die Sinterung bei niedrigeren Temperaturen und/oder kürzeren Zeiten realisiert werden kann und außerdem auch noch die Bindemetallkonzentration in den Granalien insgesamt weiter verringert werden kann.

Durch diese hergestellten gesinterten Hartmetallgranulat können für die Fertigung der Grün- und Sinterkörper aus diesem Granulat deutlich niedrigere Temperaturen zum Einsatz kommen, da es schon bei geringeren Temperaturen durch das An- und Aufschmelzen des Bindemetalls und die Bildung von Sinterhälsen zu einer Ansinterung kommt, die zu der deutlich verbesserten Gründicht und Grünfestigkeit führt.

Durch den Einsatz der hergestellten Hartmetallgranulate wird auch für die gleichzeitige oder nachfolgende vollständige Sinterung der Bauteile der Einsatz von niedrigeren Sintertemperaturen und/oder bei kürzeren Zeiten möglich.

Aufgrund des Vorhandenseins des Bindemetalls bei den hergestellten Hartmetallgranalien an der Oberfläche wird auch die Wärmeleitfähigkeit der einzelnen Granalien verbessert, so dass auch dadurch eine schnelle Sinterung bei niedrigeren Sintertemperaturen möglich ist. Im Falle des Einsatzes der erfindungsgemäß hergestellten Hartmetallgranalien beim Lasersintern kann dadurch auch der Energieeintrag deutlich gesenkt werden.

Als Hartstoffe für die erfindungsgemäße Herstellung von gesinterten Hartmetallgranalien können beispielsweise WC, TiC, TiCN, NbC, TaC, Cr₃C₂, VC und/oder Mo₂C sowie deren Mischungen eingesetzt werden, und als Bindemetalle Co, Fe und/oder Ni sowie deren Mischungen.

Weiterhin können Zusätze an Cr₃C₂, VC und/oder TaC als Kornwachstumshemmer in den Granalien eingesetzt werden.

Die mittlere Korngröße der eingesetzten Hartstoffe in den Hartmetallgranalien liegt vorteilhafterweise im Bereich von 0,05 bis 7 µm, die mittels eines Fisher Sub-Sieve Sizer klassiert worden ist.

Vorteilhafterweise wird eine Konzentration des Bindemetalls an der Oberfläche der einzelnen Granalie eingestellt, die in der Summe um 25 bis 2000 % größer ist, als im Inneren der Granalie.

Auch ist es vorteilhaft, wenn eine Verteilung des Bindemetalls an der Oberfläche der Granalien realisiert wird, die möglichst gleichmäßig über die gesamte Oberfläche der einzelnen Granalie verteilt ist und eine möglichst vollständige Oberflächenschicht aus Bindemetall auf den einzelnen Granalien realisiert wird.

Dadurch wird gleichzeitig der Zusammenhalt des in der Granalie vorhandenen Hartstoffs realisiert.

Die erfindungsgemäßen Hartmetallgranulate liegen vorteilhafterweise in Granaliengrößen von 5 µm bis 90 µm vor.

Die Granulierung und Teilverdichtung kann zum Beispiel über die Sprühtechnische/Wirbelschicht-Route oder über eine mechanische Agglomerierung/Granulierung erreicht werden. Die weitere Verdichtung der Hartmetallgranulate kann mit einer anschließenden Teil- oder vollständigen Sinterung der Granulate und vorteilhafterweise nachfolgender Deagglomeration erreicht werden.

Ebenso kann die erfindungsgemäße Herstellung des Hartmetallgranulates durch Beschichtung von mittels Sprühgranulierung und anschließender teil- oder vollständiger Sinterung zu teilweise oder vollständig verdichteten Granalien erfolgen. Nach Deagglomerierung und Klassierung der Granalien mittels Sieben und Sichten wird das Granulat mittels Physical vapor deposition/Plasma-enhanced chemical vapor deposition (PVD/PECVD) mit dem Bindemetall, wie z.B. mit Co, Ni, Fe oder deren Mischungen, beschichtet.

Eine andere Möglichkeit der erfindungsgemäßen Herstellung des Hartmetallgranulats besteht in der Führung der Sinterbindungen des Wärmebehandlungsprozesses.

Dabei werden die Granalien aus einer gemahlenen Mischung aus Hartstoff, Bindemetall und Presshilfsmitteln über Sprühgranulierung oder Wirbelschichtgranulierung hergestellt und eine Diffusion des Bindemetalls an die Oberfläche der Granalien durch Einstellung eines Kohlenstoffgradienten mit erhöhtem Kohlenstoff im Inneren der Granalien erreicht. Die Einstellung des Kohlenstoffgradienten kann beispielsweise durch eine schnelle Entbinderung mit beispielsweise 20 K/min bis 800 °C ohne Haltezeit realisiert werden.

Weiter kann durch die Steuerung der Abkühlgeschwindigkeit bei der Sinterung der Hartmetallgranalien im Dreiphasenbereich WC, Co-flüssig und C-fest die Anreicherung der Bindemetalle an der Oberfläche realisiert werden.

Das hergestellte gesinterte Hartmetallgranulat kann für additive Fertigungsverfahren und/oder für das Thermische Spritzen verwendet werden. Die additiven Fertigungsverfahren können beispielsweise Pulverbett-basierte Verfahren, wie das 3D-Pulverdrucken (Binder jetting) oder selektives Lasersintern/-schmelzen oder Elektronenstrahlschmelzen sein.

Bauteile aus den hergestellten Hartstoffgranulaten können eine höhere geometrische Freiheit aufweisen und können gleichzeitig eine hohe Stabilität solcher Bauteile als Grünkörper aufweisen.

Ebenso kann die Zersetzung der Hartstoffe oder die Bildung von unerwünschten Phasen durch zu hohen Energieeintrag vermieden werden.

Nachfolgend wird die Erfindung an mehreren Ausführungsbeispielen näher erläutert.

### Beispiel 1

Gesintertes Hartmetallgranulat wurde durch eine Mischmahlung aus WC, 16 Vol-% (entspricht 10 Ma-%) Co und 2 Ma.-% organischen Binder, hier Paraffin, in Heptan, einer anschließenden Sprühgranulierung und einer Sinterung im SinterHIP-Ofen bei 1200 °C hergestellt. Die Granulate wurden anschließend deagglomeriert und in die Fraktion ≤ 90 µm gesiebt. Anschließend wurde die Fraktion ≥ 10 µm und ≤ 32 µm mittels konventioneller Sichttechnik gewonnen.

Das so vorgesinterte Granulat wurde dann in eine PVD-Beschichtungsanlage überführt und mittels eines für die Pulverbeschichtung angepassten Rütteltisches in Bewegung gehalten. Die Beschichtung erfolgte bei 5*10⁻³ mbar mit einer angepasster Leistung (DC-Spannung) bei Raumtemperatur. Das Cobalttarget wies eine speziell für magnetische Materialien geeignete Oberflächenstrukturierung auf.

Nach der Beschichtung ist die Oberfläche der Granalien zu 90 % mit Cobalt bedeckt, wobei der Cobaltgehalt an der Oberfläche im beschichten Zustand in Summe um 565 % höher ist, als der Cobaltgehalt im Innern der Granalien.

### Beispiel 2

Gesintertes Hartmetallgranulat wurde durch eine Mischmahlung aus WC, 16 Vol-% (entspricht 10 Ma-%) Co, 0,5 Ma-% Cr₃C₂ und 2 Ma.-% organischen Binder, hier Paraffin, in Heptan, einer anschließenden Sprühgranulierung, Sichtung < 90 µm und einer Sinterung in einer sehr dünnen Schüttung im Vakuumsinterofen bei ca. 1320 °C mit einer sehr langsamen Abkühlgeschwindigkeit von 0,5 K/min bis 1150 °C hergestellt, wobei Bindemetall an die Oberfläche gedrückt wird.

Nach der Herstellung ist die Oberfläche der Granalien zu 75 % mit Cobalt bedeckt, wobei der Cobaltgehalt an der Oberfläche nun in Summe um 468 % größer ist, gegenüber dem ursprünglichen Cobaltgehalt im Innern der Granalien.

### Beispiel 3

Gesintertes Hartmetallgranulat wurde durch eine Mischmahlung aus WC, 16 Vol-% (entspricht 10 Ma-%) Co, 0,5 Ma-% Cr₃C₂ und 2 Ma.-% organischen Binder, hier Paraffin, in Heptan, einer anschließenden Sprühgranulierung, Sichtung < 90 µm und einer Entbinderung mit anschließenden Sinterung bis 1290 °C hergestellt. Bei der Entbinderung in einem N2-Ar-Gemisch wird dabei eine sehr hohe Heizrate von 20 K/min bis 800 °C ohne Haltezeit verwendet, sodass der vorhandenen organische Binders nur im Randbereich der Granalien entfernt wird und so im Innern durch die Zersetzung des organische Binders der Kohlenstoffgehalt steigt, was beim Sintern eine Diffusion des Bindemetalls an die Oberfläche bewirkt.

Nach der Herstellung ist die Oberfläche der Granalien zu 80 % mit Cobalt bedeckt, wobei der Cobaltgehalt an der Oberfläche nun in Summe um 500 % größer ist, gegenüber dem ursprünglichen Cobaltgehalt im Innern der Granalien.

## Patentansprüche

1. Verfahren zur Herstellung von gesintertem Hartmetallgranulat, bei dem Hartstoffe und Bindemetall mit oder ohne Zusätze gemischt und nachfolgend granuliert und teilverdichtet werden und nachfolgend
- einer Sinterung der Hartmetallgranalien und Steuerung der Abkühlgeschwindigkeit im Dreiphasenbereich WC, Co-flüssig und C-fest unterworfen werden,
oder
- einer Beschichtung der Hartstoffe mit Bindemetall mittels Physical vapor depositon/Plasmaenhaced chemical vapor deposition unterworfen werden
oder
- einer Entbinderung der Granalien durch Einstellung eines Kohlenstoffgradienten mit erhöhtem Kohlenstoff im Inneren der Granalien und einer nachfolgenden Sinterung unterworfen werden,
wodurch die überwiegende Anzahl an Granalien eine inhomogene Verteilung von Hartstoff und Bindemetall in der einzelnen Granalie aufweist, wobei die Konzentration des Bindemetalls an der Oberfläche der einzelnen Granalie in der Summe um mindestens 25 % größer ist, als im Inneren der Granalie.

2. Verfahren nach Anspruch 1, bei dem als Hartstoffe WC, TiC, TiCN, NbC, TaC, Cr₃C₂, VC und/oder Mo₂C und/oder deren Mischungen eingesetzt werden.

3. Verfahren nach Anspruch 1, bei dem als Bindemetalle Co, Fe und/oder Ni und/oder deren Mischungen eingesetzt werden.

4. Verfahren nach Anspruch 1, bei dem als Zusätze Cr₃C₂, VC und/oder TaC als Kornwachstumshemmer in den Granalien eingesetzt werden.

5. Verfahren nach Anspruch 1, bei dem die Hartstoffe mit einer mittleren Korngröße von 0,05 bis 7 µm, welche mittels eines Fisher Sub-Sieve Sizer klassiert worden sind, in den Hartmetallgranalien eingesetzt werden.

6. Verfahren nach Anspruch 1, bei dem eine Konzentration des Bindemetalls an der Oberfläche der einzelnen Granalie eingestellt wird, die in der Summe um 25 bis 2000 %, größer ist, als im Inneren der Granalie.

7. Verfahren nach Anspruch 1, bei dem eine Verteilung des Bindemetalls an der Oberfläche der Granalien realisiert wird, die möglichst gleichmäßig über die gesamte Oberfläche der einzelnen Granalie verteilt ist.

8. Verfahren nach Anspruch 7, bei dem eine möglichst vollständige Oberflächenschicht aus Bindemetall auf den einzelnen Granalien realisiert wird.

## Claims

1. Process for producing sintered granules of cemented hard material, wherein hard materials and binder metal are mixed with or without additives and subsequently granulated and partially densified and subsequently
- subjected to sintering of the cemented hard material granules and control of the cooling rate in the three-phase region WC, Co-liquid and C-solid,
or
- are subjected to coating of the hard materials with binder metal by means of physical vapour deposition/plasma-enhanced chemical vapour deposition or
- are subjected to binder removal from the granules by setting of a carbon gradient with increased carbon in the interior of the granules and subsequent sintering, as a result of which the predominant number of granules has an inhomogeneous distribution of hard material and binder metal in the individual granule, with the concentration of the binder metal at the surface of the individual granule being in total at least 25% greater than in the interior of the granule.

2. Process according to Claim 1, wherein WC, TiC, TiCN, NbC, TaC, Cr₃C₂, VC and/or Mo₂C and/or mixtures thereof are used as hard materials.

3. Process according to Claim 1, wherein Co, Fe and/or Ni and/or mixtures thereof are used as binder metals.

4. Process according to Claim 1, wherein Cr₃C₂, VC and/or TaC are used as additives to inhibit grain growth in the granules.

5. Process according to Claim 1, wherein the hard materials are used with an average particle size of from 0.05 to 7 µm, which have been classified by means of a Fisher sub-sieve sizer, in the cemented hard material granules.

6. Process according to Claim 1, wherein a concentration of the binder metal at the surface of the individual granule which is in total from 25 to 2000% greater than in the interior of the granule is set.

7. Process according to Claim 1, wherein a distribution of the binder metal at the surface of the granules which is very uniformly distributed over the entire surface of the individual granule is realized.

8. Process according to Claim 7, wherein a very complete surface layer of binder metal is realized on the individual granules.

## Revendications

1. Procédé pour la préparation de granulé de métal dur fritté, dans lequel des matières dures et un liant métallique sont mélangés avec ou sans additifs et ensuite granulés et partiellement comprimés et ensuite
- sont soumis à un frittage des grenailles de métal dur et à une régulation de la vitesse de refroidissement dans le domaine triphasique WC, Co-liquide et C-solide,
ou
- sont soumis à un revêtement des matières dures avec le liant métallique au moyen d'un dépôt physique en phase vapeur/dépôt chimique en phase vapeur activé par plasma
ou
- sont soumis à un retrait de liant des grenailles par ajustement d'un gradient de carbone avec une teneur en carbone plus élevée à l'intérieur des grenailles et à un frittage subséquent,
par lequel le nombre majoritaire de grenailles présente une répartition non homogène de matière dure et de liant métallique dans les grenailles individuelles, la concentration du liant métallique au niveau de la surface des grenailles individuelles étant au total au moins 25 % supérieure que dans l'intérieur des grenailles.

2. Procédé selon la revendication 1, dans lequel WC, TiC, TiCN, NbC, TaC, Cr₃C₂, VC et/ou Mo₂C et/ou leurs mélanges sont utilisés en tant que matières dures.

3. Procédé selon la revendication 1, dans lequel Co, Fe et/ou Ni et/ou leurs mélanges sont utilisés en tant que liants métalliques.

4. Procédé selon la revendication 1, dans lequel Cr₃C₂, VC et/ou TaC sont utilisés en tant qu'additifs en tant qu'inhibiteurs de croissance de grain dans les grenailles.

5. Procédé selon la revendication 1, dans lequel les matières dures dotées d'une taille de grain moyenne de 0,05 à 7 µm, qui ont été classées au moyen d'un calibreur de Fisher à tamis fin, sont utilisées dans les grenailles de métal dur.

6. Procédé selon la revendication 1, dans lequel une concentration du liant métallique au niveau de la surface des grenailles individuelles est ajustée, qui au total est 25 à 2 000 % supérieure par rapport à l'intérieur des grenailles.

7. Procédé selon la revendication 1, dans lequel une répartition du liant métallique au niveau de la surface des grenailles est réalisée, qui est répartie aussi régulièrement que possible sur la surface totale des grenailles individuelles.

8. Procédé selon la revendication 7, dans lequel une couche de revêtement aussi complète que possible du liant métallique est réalisée sur les grenailles individuelles.
